# EUROPEAN PATENT APPLICATION

(11) **EP 4 568 438 A1**
(43) Date of publication of application: **11.06.2025**
(21) Application number: 24213696.8
(22) Date of filing: 18.11.2024
(51) Int. Cl.: H05K 7/20

(54) **MODULAR MANIFOLD SYSTEM**

(30) Priority: 04.12.2023 US 202363605915 P; 13.11.2024 US 202418946406
(71) Applicant: Vertiv Corporation, Westerville, OH 43082 (US)
(72) Inventor: Wilson, Brad Lee, Westerville, 43082 (US); Grantham, Roy Lynn, Westerville, 43082 (US)
(74) Representative: Cousens, Nico

(57) **Abstract**

A modular manifold system is disclosed. The system includes a first manifold body and a second manifold body configured to couple to the first manifold body via an attachment assembly. Each manifold body includes at least one end port to fluidly communicate with an interior cavity of each manifold body, where each manifold body includes an inlet end port and an outlet end port to transfer a fluid through the respective interior cavity. At least one of the first modular body or the second manifold body includes a valve port in fluid communication with the interior cavity of a respective modular manifold body. The system further includes a hose assembly coupled to one of the first manifold body or the second manifold body via the attachment assembly.

## Description

The present application claims the benefit under 35 U.S.C. § 119(e) of U.S. Provisional Application No. 63/605,915, filed December 4, 2023.

### TECHNICAL FIELD

The present disclosure generally relates to the field of data centers, and more particularly to, a modular manifold system for data centers.

### BACKGROUND

As direct-to-chip liquid cooling becomes more pervasive, the number of different deployment options increases. For example, servers may be 1U, 2U, 3U, 6U, or the like, requiring ports with different pitches for each of the different servers. Additionally, cabinets may not be fully loaded, even though cabinet options may vary from 42U, 48U, 52U, etc. Covering this breadth of possibilities will require several different manifold stock keeping units (SKU's) and, in most cases, will require several ports to be plugged if not used. As such, it would be advantageous to provide a system or apparatus to remedy the shortcomings of the conventional approaches identified above.

### SUMMARY

A modular manifold system is disclosed, in accordance with one or more embodiments of the present disclosure. In embodiments, the modular manifold system includes a plurality of modular manifold bodies including at least a first modular manifold body and a second modular manifold body, where the first modular manifold body is configured to couple to the second modular manifold body via an attachment assembly. In embodiments, the second modular manifold body is positioned adjacent to the first modular manifold body. In embodiments, the modular manifold system includes a hose assembly coupled to one of the first modular manifold body or the second modular manifold body via the attachment assembly. In embodiments, each of the first and second modular manifold bodies include at least one end port to fluidly communicate with an interior cavity of the modular manifold body, where the first modular manifold body includes an inlet end port and an outlet end port through which to a fluid is transferred through the interior cavity of the first modular manifold body, where the second modular manifold body includes an inlet end port through which to transfer the fluid from the outlet port of the first modular manifold body to the interior cavity of the second modular manifold body, where at least one of the first modular manifold body or the second modular manifold body includes a valve port, where the valve port is in fluid communication with the interior cavity of at least one of the first modular manifold body or the second modular manifold body.

A modular manifold system is disclosed, in accordance with one or more embodiments of the present disclosure. In embodiments, the modular manifold system includes a first modular manifold body. In embodiments, the modular manifold system includes a second modular manifold body. In embodiments, the first modular manifold is configured to couple to the second modular manifold body via an attachment assembly, where the second modular manifold body is positioned adjacent to the first modular manifold body, where each of the first and second modular manifold bodies include at least one end port to communicate with an interior cavity of the modular manifold body, where the first modular manifold body includes an inlet end port and an outlet end port through which a fluid is transferred through the interior cavity of the first modular manifold body, where the second modular manifold body includes an inlet end port through which the fluid is transferred from the outlet port of the first modular manifold body to the interior cavity of the second modular manifold body, where at least one of the first modular manifold body or the second modular manifold body includes a valve port, where the valve port is in fluid communication with the interior cavity of at least one of the first modular manifold body or the second modular manifold body.

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

### BRIEF DESCRIPTION OF THE DRAWINGS

The numerous advantages of the disclosure may be better understood by those skilled in the art by reference to the accompanying figures.
FIG. 1A illustrates a schematic perspective view of a modular manifold system, in accordance with one or more embodiments of the present disclosure.
FIG. 1B illustrates a schematic view of the modular manifold system, in accordance with one or more embodiments of the present disclosure.
FIG. 1C illustrates a schematic view of the modular manifold system, in accordance with one or more embodiments of the present disclosure.
FIG. 2A illustrates a schematic view of a manifold body of the modular manifold system, in accordance with one or more embodiments of the present disclosure.
FIG. 2B illustrates a schematic view of a manifold body of the modular manifold system, in accordance with one or more embodiments of the present disclosure.
FIG. 2C illustrates a schematic view of a manifold body of the modular manifold system, in accordance with one or more embodiments of the present disclosure.
FIG. 2D illustrates a schematic view of a manifold body of the modular manifold system, in accordance with one or more embodiments of the present disclosure.
FIG. 2E illustrates a schematic view of a manifold body of the modular manifold system, in accordance with one or more embodiments of the present disclosure.
FIG. 3A illustrates a perspective view of a rack including the modular manifold system, in accordance with one or more embodiments of the present disclosure.
FIG. 3B illustrates a perspective view of a rack including the modular manifold system, in accordance with one or more embodiments of the present disclosure.
FIG. 3C illustrates a perspective view of a rack including the modular manifold system, in accordance with one or more embodiments of the present disclosure.
FIG. 3D illustrates a perspective view of a rack including the modular manifold system, in accordance with one or more embodiments of the present disclosure.
FIG. 3E illustrates a perspective view of a rack including the modular manifold system, in accordance with one or more embodiments of the present disclosure.

### DETAILED DESCRIPTION

Reference will now be made in detail to the subject matter disclosed, which is illustrated in the accompanying drawings.

In-rack manifold systems are often used to distribute even amounts of fluid to a respective server to effectuate the desired local heat exchange (e.g., at a rack or even a chip level). Proper flow distribution is important to ensure that the right amount of fluid is distributed to every server in the rack. The systems must continuously circulate fluid, as such, if there is a higher pressure drop, the system pumps must work harder than they need to.

As direct-to-chip liquid cooling becomes more pervasive, the number of different manifold deployment options can likewise increase. For example, servers may be 1U, 2U, 3U, 6U, or the like, requiring different pitches of ports for the different servers. Additionally, cabinets may not be fully loaded, even though cabinet options may vary from 42U, 48U, 52U, etc. Covering this breadth of possibilities can require several different manifold SKU's and, in most cases, may require several ports to be plugged if not used. Custom manifold systems are expensive and are rack-specific. On the other hand, existing prefabricated manifold systems are often improperly designed for the rack and disrupt proper flow distribution which can cause the system to become unbalanced and/or create high pressure drops which can cause the system pumps to work harder than they need to.

Accordingly, the present disclosure is directed to a modular manifold system. More particularly, the present disclosure is directed to a modular manifold system for use in data centers to accommodate different rack configurations (e.g., 1U, 2U, 3U, 6U, or the like). For example, the modular manifold system may allow users to adjust the configuration based on the configuration of the servers/rack. In this regard, excess ports can be minimized, and inventory can be managed more easily. Further, the manifold system may be reconfigured at a future state if servers are added and/or if the server selection changes during technology refresh.

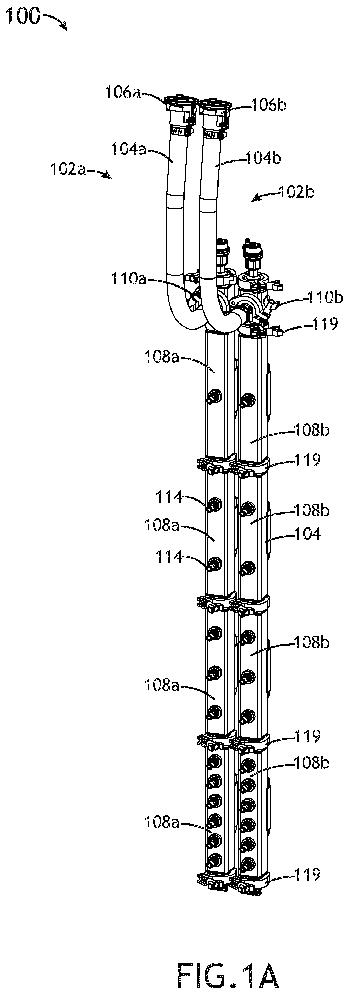

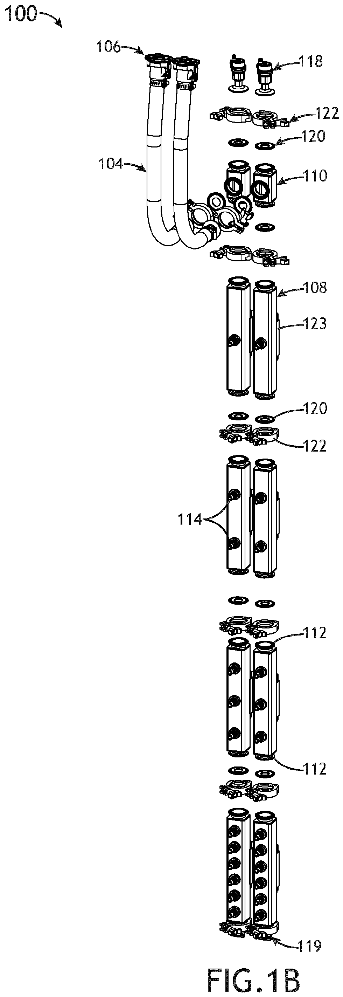

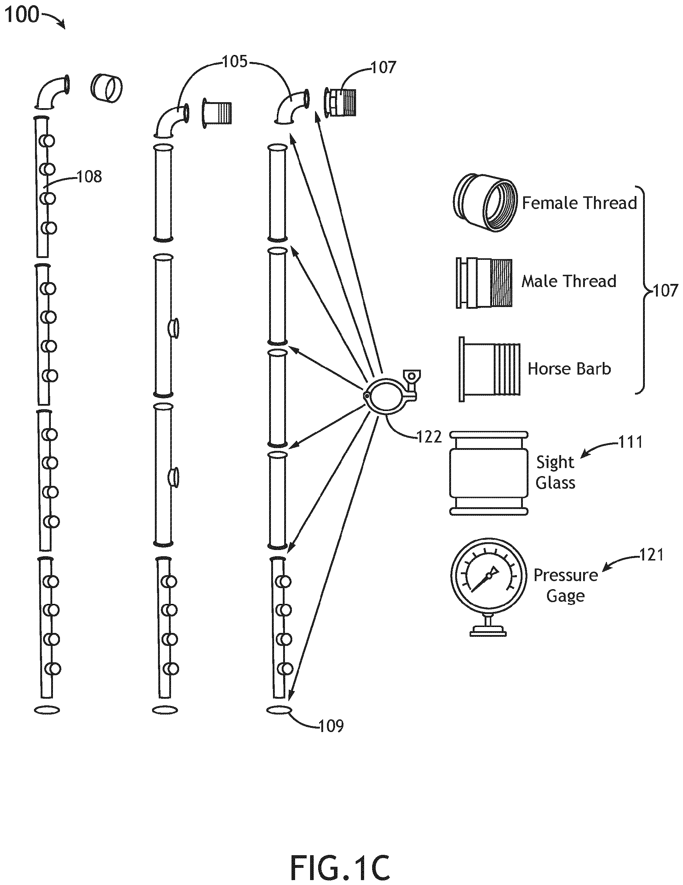

FIGS. 1A, 1B, and 1C illustrate a modular manifold system 100, in accordance with one or more embodiments of the present disclosure.

The modular manifold system 100 may include at least one supply side 102a and at least one return side 102b (or outlet side).

The supply side 102a may include at least one inlet hose 104a. For example, the inlet hose 104a of the supply side 102a may be coupled to a supply source to receive liquid (e.g., water) via a first coupling valve 106a.

The return side 102b may include at least one outlet hose 104b (or return hose). For example, the outlet hose 104b of the return side 102b may be coupled to a return source to receive used liquid (e.g., used water) via a second coupling valve 106b. In an embodiment, the used liquid may have been used in the context of a heat exchange material (e.g., a "used" liquid may have a higher temperature than an input liquid due to heat absorption from the surrounding environment (e.g., rack components)).

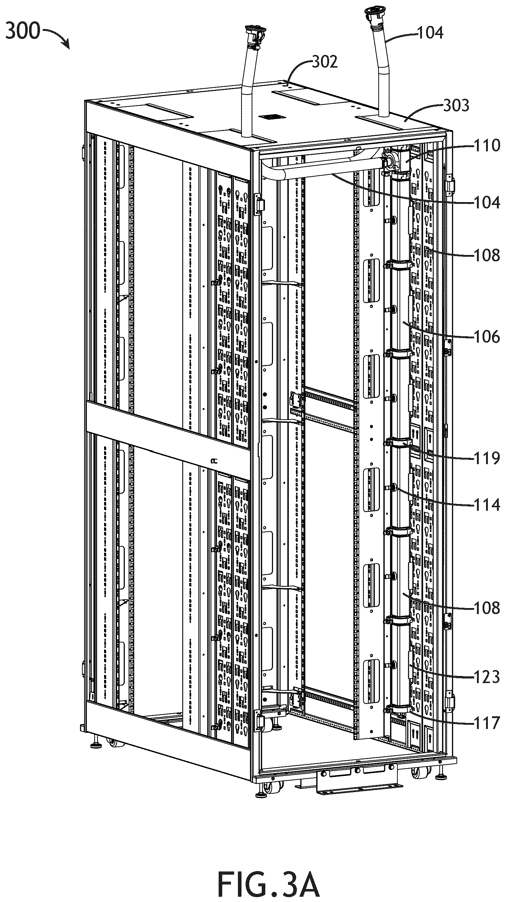

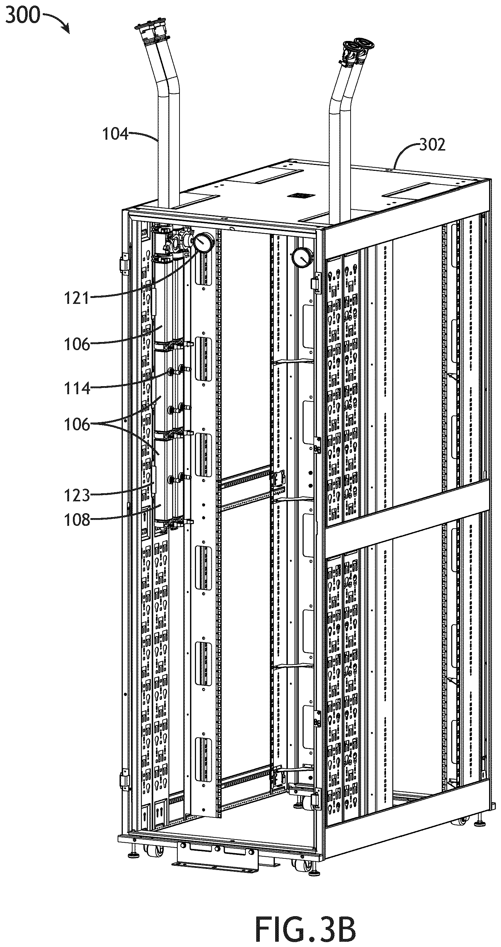

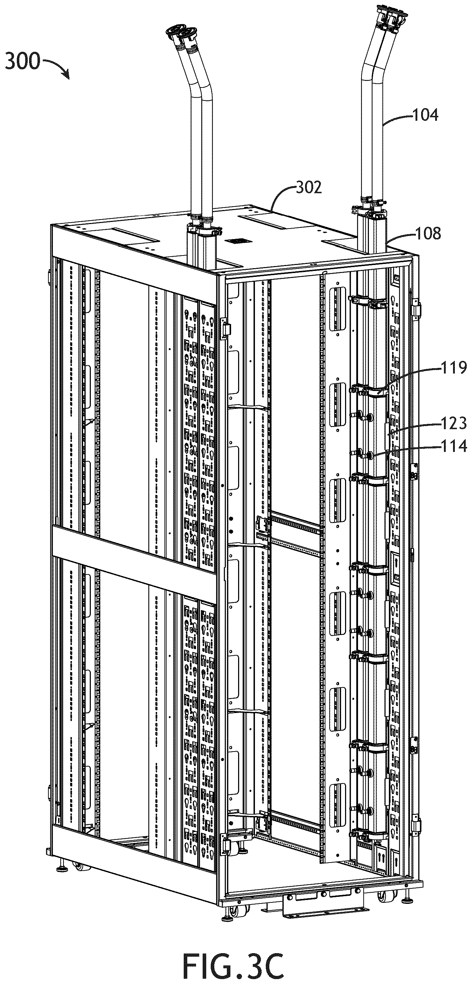

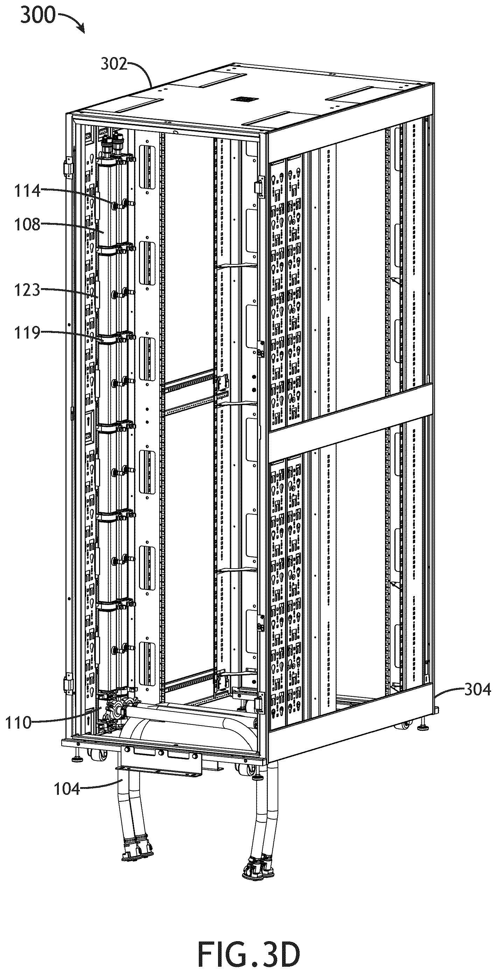

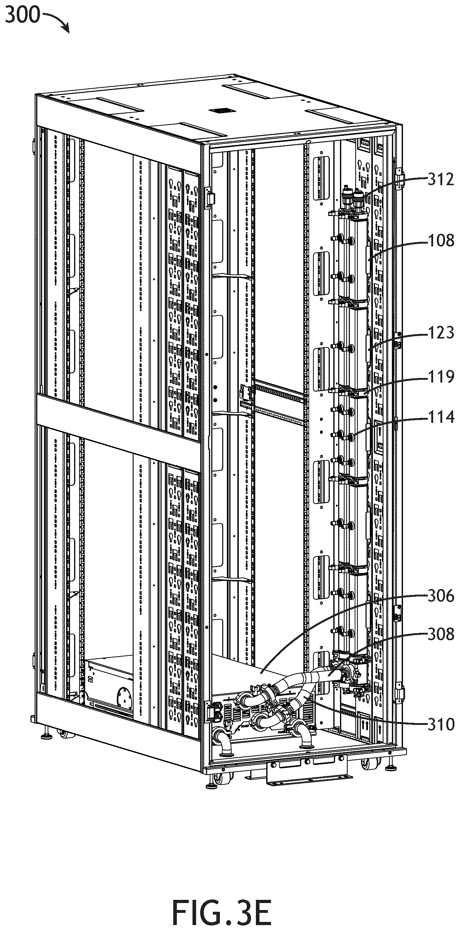

The hoses 104a, 104b may be configured to bend. For example, the hoses 104a, 104b may be formed of a bendable (or flexible material), such that the hoses 104a, 104b may be routed in a specific configuration (as discussed herein with respect to FIGS. 3A, 3B, 3C, 3D, and 3E). In an embodiment, the flexible material may be a flexible polymer (e.g., rubber or polyurethane).

Although FIGS. 1A and 1B depict the system 100 including inlet/outlet hoses 104a, 104b, it is contemplated herein that the system 100 may include one or more elbows 105 coupled to the supply side/return side 102a, 102b via one or more threaded fittings 107 (e.g., male thread, female thread fitting, hose barb, or the like), as shown in FIG. 1C. For example, the one or more elbows 105 may include one or more 90-degree sweep elbows 105.

The coupling valves 106a, 106b may include any type of coupling valve such as, but not limited to, one or more FD83 coupling values or any other suitable dry break coupling valves.

Each side 102a, 102b of the modular manifold system 100 may include one or more modular manifold bodies 108. For example, the modular manifold system 100 may include at least a first modular manifold body 108a and a second modular manifold body 108b, where the second modular manifold body 108b may be positioned adjacent to the first modular manifold body 108a. In one instance, the supply side 102a may include a set of supply manifold bodies 108a. In another instance, the return side 102b may include a set of return manifold bodies 108b. It is contemplated herein that the one or more manifold bodies 108a, 108b may be formed of any suitable material for direct-to-chip liquid cooling such as, but not limited to, one or more metals, one or more metal alloys, or the like.

At least one manifold body of the one or more manifold bodies 108a, 108b may couple to the inlet/outlet hoses 104a, 104b via one or more connection junctions 110a, 110b (e.g., inlet/outlet junctions 110a, 110b). For example, at least one supply manifold body 108a may couple to the inlet hose 104a via an inlet junction 110a (or a rotatable inlet junction). By way of another example, at least one return manifold body 108b may couple to the outlet hose 104b via an outlet junction 110b.

The connection junctions 110a, 110b (e.g., inlet/outlet junctions 110a, 110b) may be rotatable. For example, the connection junctions 110a, 110b may be configured to rotate about an axis between two or more positions. In this regard, the one or more connection junctions 110a, 110b may be rotatable to a specified position, such that the hoses 104a, 104b may be routed in a specified configuration, as discussed herein with respect to FIGS. 3A, 3B, 3C, 3D, and 3E. In some embodiments, the one or more connection junctions 110a, 110b may be rotatable between different positions.

Referring to FIG. 1B, the one or more manifold bodies 108a, 108b may include one or more end ports 112 that communicate with an interior cavity. For example, the one or more end ports 112 may act as fluid inlets and outlets to transfer fluid in/out of the interior cavity of the respective manifold bodies 108a, 108b.

At least one of the one or more manifold bodies 108a, 108b may include one or more valve ports 114. For example, the one or more valve ports 114 may act as fluid inlets and outlets to transfer fluid in/out of the interior cavity of the respective manifold bodies 108a, 108b.

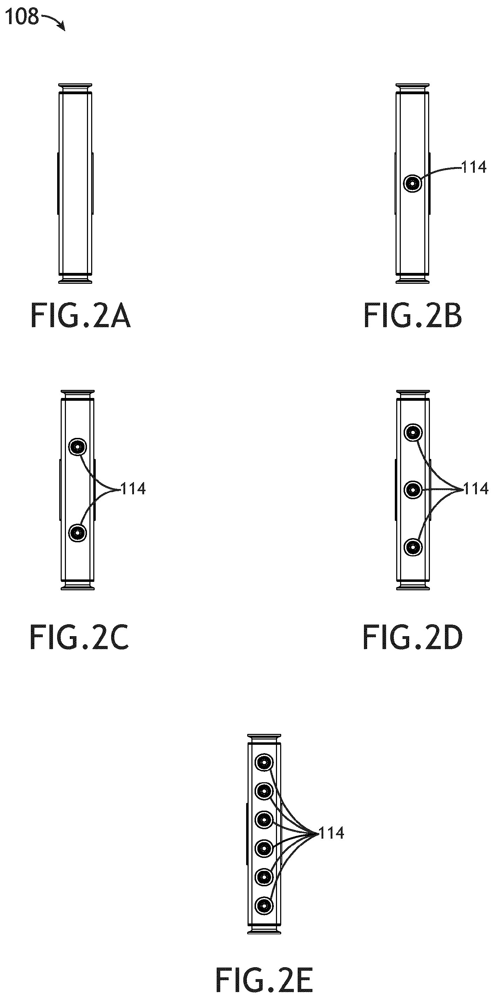

FIGS. 2A, 2B, 2C, 2D, and 2E illustrate one or more manifold bodies 108 of the modular manifold system 100, in accordance with one or more embodiments of the present disclosure.

The manifold bodies 108a, 108b may include any number and configuration of valve ports. For example, the manifold body 108 may not include a valve port (e.g., zero valve port) as shown in FIG. 2A, one valve port as shown in FIG. 2B, two valve ports as shown in FIG. 2C, three valve ports as shown in FIG. 2D, six valve ports as shown in FIG. 2E, up to an N number of valve ports (where N is an integer). By way of another example, as shown in FIG. 2A, the manifold body 108 may include a blank modular manifold body 108 (or extension manifold body 108) including zero valve ports. In this regard, as discussed further herein, the blank modular manifold body 108 may be used in the system 100 where no valve port is needed (e.g., no liquid porting is needed, due to the configuration of the servers, top of rack switches/patching devices, or the like) without requiring a valve port to be "plugged".

Further, it is contemplated that the manifold body 108 may have any length/size suitable for the current state of the rack and/or future state of the rack. For example, the manifold body 108 may include a 6U x 6 port manifold body. By way of another example, the manifold body 108 may include a 6U x 3 port manifold body. By way of another example, the manifold body 108 may include a 6U x 2 port manifold body. By way of another example, the manifold body 108 may include a 6U x 1 port manifold body. By way of another example, the manifold body 108 may include a 6U blank manifold body. By way of another example, the manifold body 108 may include a 12U blank manifold body.

As previously discussed herein, excess ports can be minimized, and inventory can be managed more easily. Further, the manifold system 100 may be reconfigured at a future state if servers are added and/or if the server selection changes during a technology refresh.

Referring back to FIGS. 1A, 1B, and 1C, the modular manifold system 100 may include one or more drain fittings. For example, the modular manifold system 100 may include one or more drain valves 117 (see FIG. 3A). By way of another example, the modular manifold system 100 may include one or more end caps 109 (e.g., threaded or non-threaded end caps). By way of another example, the modular manifold system 100 may include one or more sight glasses 111 to monitor a liquid level within the system 100.

The modular manifold system 100 may include one or more auto-vents 118.

The modular manifold system 100 may include one or more pressure gauges 121. In an embodiment, a pressure gauge 121 can be an analog or digital gauge and may be plumbed inline or as an attachment.

The one or more components of the modular manifold system 100 may be fluidly coupled together via one or more attachment assemblies 119. For example, the one or more attachment assemblies 119 may include a gasket 120 (e.g., tri-clamp gasket) and a clamp 122 (e.g., tri-clamp). It is noted that the attachment assemblies may include any type of fastener suitable for fluidly coupling the respective components together (e.g., hoses 104, inlet/outlet junctions 110, manifold bodies 108, auto-vents 118, and the like).

In some embodiments, the one or more attachment assemblies 119 may allow for the ability to "hot swap" respective modular manifold bodies 108 of the system 100. In this regard, the attachment assemblies 119 may be configured to isolate the fluid within the internal cavity of the respective modular manifold body 108 and/or allow the respective manifold body 108 to be drained, such that the respective manifold body 108 may be easily replaced without draining the entire system 100. For example, the attachment subassemblies 119 may further include one or more valves (e.g., ball valves) to isolate the fluid. However, it is contemplated that the attachment assemblies 119 may include any suitable attachment assembly.

FIGS. 3A, 3B, 3C, 3D, and 3E illustrate one or more racks 300 including the modular manifold system 100, in accordance with one or more embodiments of the present disclosure.

It is contemplated that FIGS. 3A,3B, 3C, 3D, and 3E are provided merely for illustrative purposes and depict the modularity of the system 100. As previously discussed herein, the modular manifold system 100 may allow for customization and reconfiguration based on a current and/or future state of the rack (e.g., if servers are added/removed, other equipment is installed/removed, or the like). In this regard, the modular manifold system 100 allows for the creation of a more optimum manifold to fit the desired application with a minimum number of modular components.

Referring to FIG. 3A, a single manifold configuration is shown, where a single manifold is mounted on each side (e.g., supply and return side) and the hoses are routed horizontally. For example, the hoses 104a, 104b may be routed vertically through a roof panel 302. The roof panel 302 may include one or more brushes 303 to allow cables or hoses to pass through the roof panel while preventing excessive air to bypass.

The modular manifold body 108 may include a 6U length manifold body 108, where each of the manifold body 108 includes a single port 106.

The inlet/outlet junction 110a, 110b may rotate about a vertical axis of the rack 300 for easy hose routing. For example, the inlet/outlet junction 110a, 110b may be rotated approximately 90 degrees to allow the hoses to be routed horizontally within the rack 300, where the flexibility of the hoses allows them to be routed vertically though the roof panel 302.

The modular manifold body 108 may include one or more mounting brackets 123 to mount the modular manifold body 108 within a rack 300. For example, as shown in FIG. 3A, the one or more mounting brackets 123 may include one or more hanger "buttons" to secure the manifold 108 to a power distribution unit (PDU) bracket.

Referring to FIG. 3B, a double manifold configuration is shown, where a double manifold (e.g., two manifolds) are mounted on each side and the hoses are mounted vertically. For example, the hoses 104a, 104b may be routed vertically though the roof panel 302.

One side of the system may include a first manifold/port configuration and the other side of the system may include a different manifold/port configuration. For example, as shown in FIG. 3B, one side has a three-section length configuration, and the other side has a full-length configuration. Further, each modular manifold body 108 of either side may include a different port configuration. For example, the first body may include a blank extension, the second body may include two ports, and the third body may include one port.

The manifold system 100 may include the pressure gauge 121 mounted at the top of the rack 300 to monitor pressure. As previously discussed herein, high pressure drops can cause the system pumps to work harder than they need to, as such minimizing such high-pressure drops is desirable.

Referring to FIG. 3C, a double manifold configuration is shown, where a double manifold (e.g., two manifolds) are mounted on each side and the manifolds extend through roof panel 302. For example, a blank manifold (or extension) may be used to extend the manifold through the roof panel for hose connection, where the hoses are routed vertically through the roof panel 302.

Referring to FIG. 3D, a double manifold configuration is shown, where a double manifold (e.g., two manifolds) are mounted on each side and the hoses are routed horizontally through the rack bottom 304.

The inlet/outlet junction 110a, 110b may rotate about a horizontal axis of the rack 300 for easy hose routing. For example, the inlet/outlet junction 110a, 110b may be rotated approximately 90 degrees down allow the hoses to be routed vertically down through the rack bottom 304.

Referring to FIG. 3E, a double manifold configuration is shown, where one side of the rack 300 includes a double manifold (e.g., two manifolds) and the hoses are routed to a bottom mounted in-rack coolant distribution unit (CDU) 306. For example, the inlet hose may include a CDU supply hose 308 and the outlet hose may include a CDU return hose 310 each coupled to a respective manifold body 108.

The manifold system 100 may include an automatic bleeder vent valve 312 coupled to the top of the manifold 108.

Although embodiments of the present disclosure are directed towards a modular manifold system 100 for a rack 300 within a data center, it is contemplated herein that the modular manifold system 100 may be used for any critical infrastructure application (e.g., museums, hospitals, office buildings, and the like).

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

While particular aspects of the present subject matter described herein have been shown and described, it will be apparent to those skilled in the art that, based upon the teachings herein, changes and modifications may be made without departing from the subject matter described herein and its broader aspects and, therefore, the appended claims are to encompass within their scope all such changes and modifications as are within the scope of the subject matter described herein. Furthermore, it is to be understood that the invention is defined by the appended claims.

## Claims

1. A modular manifold system, the modular manifold system comprising:
a plurality of modular manifold bodies including at least a first modular manifold body and a second modular manifold body, wherein the first modular manifold body is configured to couple to the second modular manifold body via an attachment assembly, wherein the second modular manifold body is positioned adjacent to the first modular manifold body; and
a hose assembly coupled to one of the first modular manifold body or the second modular manifold body via the attachment assembly,
wherein each of the first and second modular manifold bodies includes at least one end port to fluidly communicate with an interior cavity of each modular manifold body, wherein the first modular manifold body includes an inlet end port and an outlet end port through which a fluid is transferred through the interior cavity of the first modular manifold body,
wherein the second modular manifold body includes an inlet end port through which the fluid is transferred from the outlet end port of the first modular manifold body to the interior cavity of the second modular manifold body, and
wherein at least one of the first modular manifold body or the second modular manifold body includes a valve port, wherein the valve port is in fluid communication with the interior cavity of at least one of the first modular manifold body or the second modular manifold body.

2. The modular manifold system of Claim 1, wherein at least one of the first modular manifold body or the second modular manifold body includes a blank modular manifold body.

3. The modular manifold system of Claim 1 or 2, wherein the attachment assembly comprises:
a gasket and a clamp, and/or
further comprising at least one of a pressure gauge, an auto-vent, or a drain fitting.

4. The modular manifold system of any preceding Claim, wherein the hose assembly comprises:
an inlet hose sub-assembly coupled to a supply source, wherein the inlet hose sub-assembly is coupled to a respective modular manifold body of the plurality of modular manifold bodies via an inlet junction to transfer the fluid from the supply source to the respective modular manifold body of the plurality of modular manifold bodies via the inlet hose sub-assembly; and
an outlet hose sub-assembly coupled to a return source, wherein the outlet hose sub-assembly is coupled to a respective modular manifold body of the plurality of modular manifold bodies via an outlet junction to transfer the fluid from the respective modular manifold body of the plurality of modular manifold bodies to the return source to via the outlet hose sub-assembly.

5. The modular manifold system of Claim 4, wherein the inlet hose sub-assembly comprises a flexible inlet hose, and/or
wherein the outlet hose sub-assembly comprises a flexible outlet hose.

6. The modular manifold system of Claim 4 or 5, wherein the inlet junction comprises a rotatable inlet junction configuration to rotate between two or more positions, and/or
wherein the outlet junction comprises a rotatable outlet junction configuration to rotate between two or more positions.

7. A modular manifold system, the modular manifold system comprising:
a first modular manifold body; and
a second modular manifold body,
wherein the first modular manifold body is configured to couple to the second modular manifold body via an attachment assembly,
wherein the second modular manifold body is positioned adjacent to the first modular manifold body,
wherein each of the first and second modular manifold bodies include at least one end port to communicate with an interior cavity of each modular manifold body,
wherein the first modular manifold body includes an inlet end port and an outlet end port through which a fluid is transferred through the interior cavity of the first modular manifold body,
wherein the second modular manifold body includes an inlet end port through which fluid is transferred from the outlet end port of the first modular manifold body to the interior cavity of the second modular manifold body, and
wherein at least one of the first modular manifold body or the second modular manifold body includes a valve port, wherein the valve port is in fluid communication with the interior cavity of at least one of the first modular manifold body or the second modular manifold body.

8. The modular manifold system of Claim 7, wherein at least one of the first modular manifold body or the second modular manifold body includes a blank modular manifold body.

9. The modular manifold system of Claim 7 or 8, wherein the attachment assembly comprises:
a gasket and a clamp, and/or
further comprising at least one of a pressure gauge, an auto-vent, or a drain fitting.

10. The modular manifold system of any of Claims 7 to 9, further comprising:
a hose assembly coupled to one of the first modular manifold body or the second modular manifold body via the attachment assembly.

11. The modular manifold system of Claim 10, wherein the hose assembly comprises:
an inlet hose sub-assembly coupled to a supply source, wherein the inlet hose sub-assembly is coupled to a respective modular manifold body via an inlet junction to transfer the fluid from the supply source to the respective modular manifold body via the inlet hose sub-assembly; and
an outlet hose sub-assembly coupled to a return source, wherein the outlet hose sub-assembly is coupled to a respective modular manifold body via an outlet junction to transfer the fluid from the respective modular manifold body to the return source to via the outlet hose sub-assembly.

12. The modular manifold system of Claim 11, wherein the inlet hose sub-assembly comprises a flexible inlet hose.

13. The modular manifold system of any of Claims 11 or 12, wherein the outlet hose sub-assembly comprises a flexible outlet hose.

14. The modular manifold system of any of Claims 11 to 13, wherein the inlet junction comprises a rotatable inlet junction configuration to rotate between two or more positions.

15. The modular manifold system of any of Claims 11 to 14, wherein the outlet junction comprises a rotatable outlet junction configuration to rotate between two or more positions.
